# EUROPEAN PATENT APPLICATION

(11) **EP 4 589 807 A1**
(43) Date of publication of application: **23.07.2025**
(21) Application number: 24153101.1
(22) Date of filing: 22.01.2024
(51) Int. Cl.: H02J 13/00, G01D 4/00, G01R 19/25

(54) **MEASURING DEVICE TO MONITOR MAINS SUPPLY OF A BUILDING INFRASTRUCTURE**

(71) Applicant: Tridonic GmbH & Co. KG, 6851 Dornbirn (AT)
(72) Inventor: Zengerle, Thomas, 6851 Dornbirn (AT); Ladurner, Simon, 6851 Dornbirn (AT); Schmölzer, Andreas, 6851 Dornbirn (AT); Hüttinger, Ulrich, 6851 Dornbirn (AT)
(74) Representative: Beder, Jens

(57) **Abstract**

The present invention provides measuring device to monitor mains supply of a building infrastructure system. The measuring device comprises a terminal configured to connect the measuring device to a grid supplying the building infrastructure system with electric power, measuring means configured to generate measurement values on at least one physical quantity of the mains supply connected to the terminal over time. The measuring device also comprises a communication interface configured to enable transfer of the measurement values and/or an analysis result obtained by processing the measurement values in the measuring device to an external device.

## Description

The invention relates to the field of technical building infrastructure and, in particular, concerns a measuring device to monitor mains supply of a building infrastructure system, a corresponding measuring method, and the corresponding building infrastructure system comprising the measuring device.

The technical building infrastructure includes infrastructure systems that typically arrange a large number of devices over the extensive area of a building. For example, for a building infrastructure system being or comprising a lighting system, the devices may include luminaires, lighting modules for emitting light, light drivers for driving the lighting modules, presence detectors, switches, dimmers, further control gear, lighting system management servers, dedicated communication equipment for a DALI^{™} ,or Bluetooth mash (Casambi, ZigBee^{™} ,etc.) or IP based ZigBee^{™} network (matter), and emergency power supply including batteries for storing electric energy.

A power grid within the building provides electric energy via mains supply to the devices of the lighting system and extends over the entire building. Characteristically, the mentioned devices of the lighting system include electrical circuitry consisting of electrical components, whose lifespan may depend among other things on the characteristics of the mains supply over time. For example, frequent occurrences of voltage surges or spikes on the mains supply lines may adversely affect the lifespan of a connected electric circuit, and therefore the respective device, or lead to complete failure of the respective device.

Current light drivers may already include basic measurement capabilities, via for example an integrated sensor circuit, concerning a mains supply current and the mains supply voltage, for example, for estimating a power consumption as an internal parameter of the LED driver. They often include a communication capability based on a light standard such as DALI^{™} or DALI 2^{™} standard, which enables to provide sensor data including obtained parameter values, and an evaluation signal generated based on the sensor data, to other elements of the building infrastructure system.

In order to predict a life expectancy reliably for the distributed devices of the building infrastructure system, or to perform predictive maintenance for the lighting system, information on the physical quantity of the mains supply, such as mains supply input voltage, and a mains supply input current are required. Light drivers exist already that can provide limited information on mains characteristics. However, they cannot monitor mains distortions like burst or surge pulses sufficiently accurate.The information they provide is limited in resolution and often insufficient for root cause analysis of defective light drivers. Also the Lighting management systems are typically not equipped for collecting information for driver usage analytics. Moreover, the information from mains monitoring and light driver are not easily externally accessible from outside of the building infrastructure system.

Therefore, it is an object of the invention to provide information with high resolution on the mains supply in the building infrastructure system. It is in particular an object of the invention to provide unlimited measurement values with high resolution on physical quantity of the mains supply.

The measuring device and corresponding method and system according to the independent claims solve the aforementioned problem.

The first aspect of the invention concerns a measuring device to monitor mains supply of a building infrastructure system. The measuring device comprises a terminal configured to connect the measuring device to a grid supplying the building infrastructure system with electric power, measuring means configured to generate measurement values on at least one physical quantity of the mains supply connected to the terminal over time. The measuring device also comprises a communication interface configured to enable transfer of the measurement values and/or an analysis result obtained by processing the measurement values in the measuring device to an external device.

The measuring device according to the first aspect of the invention aims to monitor the mains quality in great detail and to provide a detailed overview of the building infrastructure system. The building infrastructure system arranges a plurality of building infrastructure devices, for example light drivers, in particular LED drivers, all over the building. All individual infrastructure devices may be connected with mains supply directly or over the measuring device. Monitoring of the mains quality is essential as it is a key factor that impacts the performance of building infrastructure devices and the overall building infrastructure system.

In the building infrastructure system, individual luminaires and light drivers are connected via a communication network. A DALI^{™}, Bluetooth mesh or IP based network for example, becomes increasingly state of the art. The following explanations may use DALI^{™} as an example. However, the explanations are also valid for the other mentioned network systems.

The light driver connected to the building infrastructure system via the DALI^{™} network, provides the data generated by the light driver, which are used for additional applications as well, for example, tracking of power consumption, tracking of the light current, communicating an actual demo letter and indicating current failure modes. Furthermore, internal states of the light driver may be determined and the internal states communicated via DALI^{™} interface of the light driver to interfaces of other light drivers, and in particular to an external device over the measuring device or directly over DALI^{™}.

The invention uses the measuring device as a monitoring device for measuring physical quantities of the mains supply, which are valid for and make an impact on a plurality of light drivers.

In particular, the measuring device generate measures values on physical quantities of the mains supply over time in high resolution and reports the measurements values and/or analysis results obtained by processing at least a portion of the stored measurement values to an external device, for example, to a system management server. This enables an operator of the building infrastructure system to become aware of, for example, characteristics of the mains supply of the corresponding building infrastructure system, and therefore of basic requirements concerning the ability to cope with voltage spikes, for example, for connecting new infrastructure devices to the mains supply or for replacing faulty building infrastructure devices or guarantee of a faulty device.

The second aspect of the invention concerns a method for monitoring mains supply of a building infrastructure system comprising a measuring device according to the first aspect of the invention that solves the aforementioned problem. The method comprises the step of generating, by measuring means, measurement values on at least one physical quantity of the mains supply connected to the terminal over time. The method proceed by the step of transferring, by communication interface, the measurement values and/or an analysis result obtained by processing at least a portion of the measurement values in a measuring device to an external device. The method further comprises the step of communicating with at least one building infrastructure device.

The method for monitoring mains supply according the invention achieve corresponding advantages.

The third aspect of the invention concerns a building infrastructure system, which comprises a measuring device according to first aspect of the invention, at least one building infrastructure device comprising a light driver, in particular a LED driver, and at least one external device.

The building infrastructure system may comprise a lighting system.

The dependent claims define further advantageous embodiments of the invention.

The measuring device according to an embodiment may further comprise a data storage storing at least a plurality of the measurement values and their respective timestamps. This allows an efficient storage and retrieval of measured values in the measuring device or information collected from the light drivers. These values and/or information can then be used for troubleshooting purposes and/or for gaining insights into the condition of the light drivers or for conducting information analytics.

The measuring device according to an embodiment may further comprise a processing unit configured to execute an analysis of at least a portion of the stored measurement values. This enables the measuring device to analyze of least a portion of physical quantities of the mains supply and their variations over time to detect an event defined based on measured respective physical quantity of the mains supply.

According to an embodiment the communication interface may be further configured to transfer the measurement values and/or the analysis result to an external data storage. This may enable system owners, manufacturers or support engineers with detailed analyses and monitoring of the measurement values for troubleshooting or detecting product guarantee cases.

The physical quantity of the mains supply may comprise at least one of a mains supply voltage, a mains supply input current and a mains supply frequency.

The measuring device according to an embodiment may be further configured to read in information from at least one building infrastructure device, and to store the information in the data storage and/or to send the read in information from the at least one building infrastructure device to the external device or the external data storage. In this way the system owners, the manufacturer or support engineers can have access to these information for an offline or online analyses. The information from at least one building infrastructure device may indicate an detected event, for example, actual parameter values measured by the respective building infrastructure device, current ranges of the actual parameter values, current counter values of the event counter and/or define an event type.

The measuring device according to an embodiment may further comprise a control means configured to generate and output a control signal for controlling operation of the at least one building infrastructure device. The control signal can control the operation of a light driver via controlling an AC/AC converter or a relay, wherein the AC/AC converter may be integrated in the measuring device or may be placed outside of the measuring device in the building infrastructure system.

The control means may be configured to output the control signal to disconnect the at least one building infrastructure device from the mains supply. In this way, the measuring device can, if necessary, disconnect the at least one building infrastructure device, in particular the light drivers from the mains supply, for example in case of a large number of voltage spikes or persistent over-voltages, to protect the building infrastructure devices from a damage, realizing a protective function for the building infrastructure devices.

The measuring device according to an embodiment may further comprises the AC/AC converter to optimize the at least one physical quantity of the mains supply based on the analysis result. In this way the available voltage on the supply side of the building infrastructure device can be influenced. A sweep and a measurement can then be carried out in the measuring device across different supply voltages at which voltage the connected lighting system works optimal, for example, with regard to energy consumption. The AC/AC converter may be arranged inside the measuring device as one of its units or may be arranged outside of the measuring device in the building infrastructure system.

The measuring device according to an embodiment may in addition or alternatively comprise a filter configured to provide filtered mains supply to the at least one building infrastructure device. This may prevent network transients and over-voltages from reaching the building infrastructure devices and hereby realizing a further protective function for the building infrastructure devices. The measuring device may comprise the filter instead of the AC/AC converter and/or together with the AC/AC converter. The filter may be connected after or before the AC/AC converter in the measuring device.

The measuring device according to an embodiment may be further configured to optimize a driver parameter of the at least one building infrastructure device based on the analysis result obtained by processing the measurement values in the measuring device, and to output the optimized driver parameter of the at least one building infrastructure device the corresponding building infrastructure device. In this way, the measuring device can test certain operating parameters, such as different supply voltages via AC/AC converter. The measuring device can then independently use the operating parameter at which the device functions most efficiently, and hereby realizing a function of automatically optimizing the parameters for the operation of the building infrastructure devices.

The measuring device according to an embodiment may be further configured to read in a driver firmware packet or a driver software of the at least one building infrastructure device and to store the driver firmware packet or the driver software of the at least one building infrastructure device in the data storage, and to update a driver firmware or the driver software of the at least one building infrastructure device. A firmware update for building infrastructure devices, such as sensors, EMY, light drives, etc. can take hours. The measuring device can automate this process. This means that the measuring device can be simply integrated into the DALI^{™}, and the update can be carried out automatically, for example overnight. In this way, an expert can remotely plan the update itself and thereby efforts and costs can be reduced.

The measuring device may be configured to update the driver firmware packet or the driver software of the at least one building infrastructure device automatically at a predetermined time or in response to a predetermined condition. In this way, the driver firmware packet or the driver software of the at least one building infrastructure device can be updated effectively, e.g., at a time, when the respective building infrastructure device is not in use.

In the following, the invention is described exemplarily with reference to the enclosed figures, in which
**Figure 1** is a schematic overview of the structure of a measuring device for monitoring mains supply of a building infrastructure system according to an embodiment;
**Figure 2** is a simplified flowchart of a method for monitoring mains supply of a building infrastructure system according to an embodiment;

In the figures, corresponding elements have the same reference signs. The proportions and dimensions of the elements shown in the figures do not represent unit to scale, but are merely chosen to describe the structure and function of the measuring device.

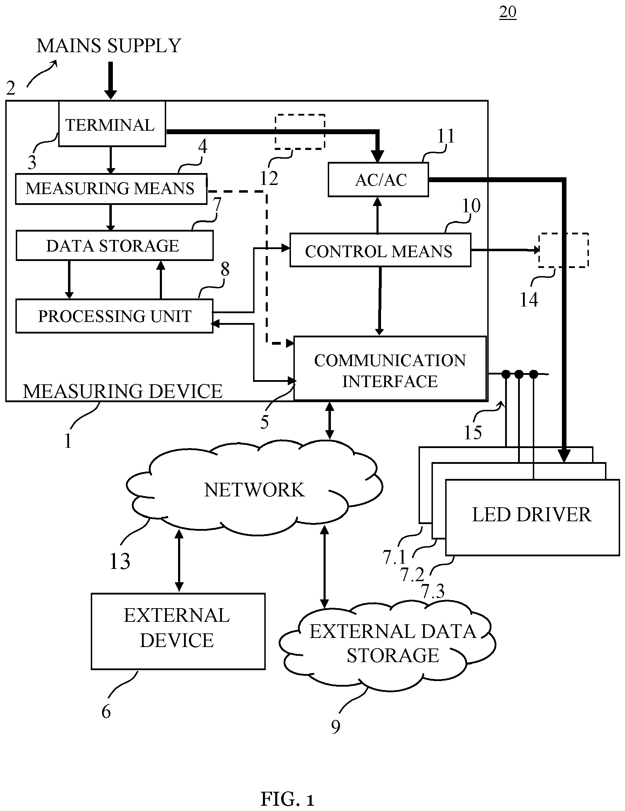

Figure 1 provides a schematic overview of the structure of a measuring device 1 for monitoring mains supply of a building infrastructure system 20 according to an embodiment. Figure 1 shows the measuring device 1 as part of a building infrastructure system 20. Figure 1 in particular depicts the building infrastructure system 20 as a lighting system 20 containing the measuring device 1.

The lighting system 20 comprises a plurality of structural components arranged in the environment. The environment of the lighting system 20 is the interior of a building. The environment of the lighting system 20 may include all spaces, which light emitting elements of the lighting system 20, in particular, all lighting modules (not explicitly shown) illuminate or are capable to illuminate.

Figure 1 shows an example of the functional blocks of a measuring device 1 in a lighting system 20 according to the first aspect of the invention. The measuring device 1 includes a terminal 3 connected to mains supply 2 of the lighting system 20. The lighting system 20 comprises in particular a plurality of LED drivers 7.1, 7.2, 7.3. The LED drivers 7.1, 7.2, 7.3 have each a mains supply interface (not shown), which provide the LED drivers 7.1, 7.2, 7.3 with electric energy, optionally from the power grid of the building directly (not shown) or via a filter 12 and/or via a AC/AC converter 11 or a combination thereof from the power grid of the building. The mains supply 2 is characteristically, but not limited to an AC mains supply.

The measuring device 1 includes only those structural units in figure 1, which are of particular relevance for monitoring mains supply 2 of a lighting system.

The building has a mains supply grid providing electric energy via a main supply 2 to each of the structural elements of the lighting system 20.

The measuring device 1 includes a communication interface 5. The communication interface 5 enables the measuring device 1 to communicate with other elements of the lighting system 20 via a lighting network 13 (network 13). The communication interface 5 may comprise or may be connected to an interface according to the Digital Addressable Lighting Interface (DALI^{™}) standard, the DALI-2^{™} standard, D4i standard or any other interface standard applied in the field of technical building infrastructure.

The network 13 may be a wired communication network or, alternatively, a wireless network. The network 13 may use both wired and wireless communication.

The lighting system 20 further includes an external device 6 and external data storage 9, which are in wired or wireless connection (over network 13) with the measuring device 1 via communication interface 5. The external device 6 may be a system management server or provide an interface with a support engineer.

The measuring device 1 includes measuring means 4 connected to the terminal 3.

The measuring means 4 obtains measurement values on physical quantity of the mains supply 2. Obtaining measurement values on the physical quantity of the mains supply 2 may comprise measuring actual values for the at least one physical quantity. Obtaining measurement values on the at least one physical quantity of the mains supply 2 may comprise determining representative values for the actual values of the at least one physical quantity.

The measuring means 4 may provide the obtained measurement values on the physical quantity of the mains supply 2 to the communication interface 5 for reporting to the external device 6 and/or for storing in the external data storage 9 over the network 10. In addition or alternatively, the measuring means 4 may provide the obtained measurement values on the physical quantity of the mains supply 2 to an internal data storage 7.

The data storage 7 may send the measurement values to a processing unit 8 and may then receive an analysis of at least a portion of the measurement values from the processing unit 8. The processing unit 8 may also receive information containing events from at least one LED driver 7.1, 7.2, 7.3 delivered over DALI^{™} to the communication interface 5 and send them to the data storage 7 to store them.

It is to be noted that the measuring device 1, in addition to the characteristics obtained by the measuring means 4, may be configured to log data from the channels of the data bus 15 used for controlling and communication. Such data logging is indicated in fig. 1 by the arrow connecting the processing unit 8 and the communication interface 5. The logged data may be stored in the internal data storage 7 and can be read out for external processing or used for internal data analysis inside the measuring device 15. This is particularly useful for identifying correlations between events that can be observed from communication on the bus 15 with events that can be identified from measurements performed by the measuring means 4

The processing unit 8 may be a microcontroller or ASIC to execute an analysis of at least a portion of the stored measurement values and may send the analysis results to the communication interface 5 for reporting purposes and/or to a control means 10 for controlling purposes.

The processing unit 8 may compare the obtained measurement values with the stored events, and assign the corresponding event with the obtained measurement values.

The measuring device 1 may include control means 10 to generate and output a control signal for controlling operation of the at least one building infrastructure device.

The processing unit 8 may provide the analyses results to the control means 10 and/or to the communication interface 5.

The control means 10 can then control an operation of a relay 14 connecting the light drivers to the mains supply and/or an operation of a LED driver 7.1, 7.2, 7.3 via communication interface 5 and/or DALI bus 15 individually.

The measuring device 1 may include an AC/AC converter 11 to optimize the at least one physical quantity of the mains supply 2 based on the analysis result sent to the control means 10.

The control means 10 can control an operation of the AC/AC converter 11 in addition or alternatively to the operation of the relay 14 connecting the LED drivers 7.1, 7.2, 7.3 to the mains supply, in addition or alternatively to an operation of a LED driver 7.1, 7.2, 7.3 via communication interface 5 and/or DALI bus 15 individually.

The electric energy of a LED driver 7.1, 7.2, 7.3 or a group of LED driver 7.1, 7.2, 7.3 is provided optionally from the power grid of the building directly (not explicitly shown) or via the AC/AC converter 11 from the power grid of the building and/or via a relay.

Alternatively, the AC/AC converter 11 may be located outside of the measuring device 1 in the building infrastructure system.

The measuring device 1 may include the filter 12 to provide filtered mains supply to the LED drivers 7.1, 7.2, 7.3 in series with the AC/AC converter. It is to be noted that the AC/AC converter is only included in case that the measuring device shall be used as the power source for the LED drivers 7.1, 7.2, 7.3.

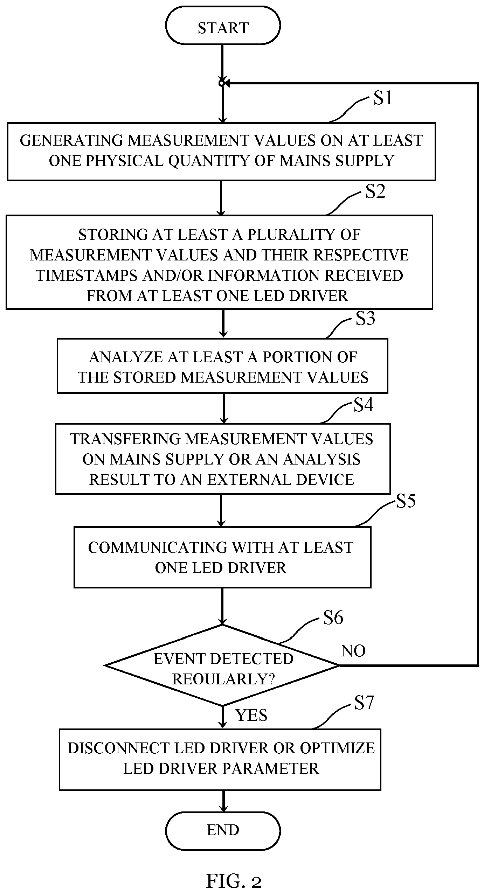

Fig. 2 is a simplified flowchart of the method for monitoring mains supply 2 of a building infrastructure system 20 according to an embodiment.

The method for monitoring mains supply 2 of uses a monitoring device 1 in a building infrastructure system 20.

The method starts with a step S1 of generating, by the measuring means 4, measurement values on at least one physical quantity of the mains supply 2 connected to the terminal 3 over time.

In step S2, the data storage 7 stores at least a plurality of the measurement values and their respective timestamps and/or information received from at least one building infrastructure device 7.1, 7.2, 7.3, in particular from a LED driver 7.1, 7.2, 7.3.

In step S3, the processing unit 8 executes an analysis of at least a portion of the stored measurement values.

In particular, the method may compare the obtained measurement values on at least one physical quantity of main supply 2 with received information, in particular received events, from the at least one building infrastructure device 7.1, 7.2, 7.3 to assign and/or link the processes on the mains supply 2 with the received events from the at least one building infrastructure device 7.1, 7.2, 7.3.

Additionally, the received information may include the type of event from the at least one building infrastructure device 7.1, 7.2, 7.3, in particular from the at least one LED driver 7.1, 7.2, 7.3.

The method proceeds with step S4 and transfer the measurement values and/or an analysis result obtained by processing at least a portion of the measurement values in the measuring device 1 to an external device 6.

In step S5, the method proceeds by communicating with at least one building infrastructure device 7.1, 7.2, 7.3, in particular with at least one LED driver 7.1, 7.2, 7.3.

If the method determines in step S6, that no event is detected regularly based on the received events from the at least one LED driver 7.1, 7.2, 7.3, the method returns to step S1 and generate measurement values on at least one physical quantity of the mains supply 2.

If the method determines in step S6, that an event is detected regularly based on the received events from the at least one LED driver 7.1, 7.2, 7.3, the method proceeds with step S7 and disconnect the respective LED driver 7.1, 7.2, 7.3 or optimize at least one light driver parameter.

All steps which are performed by the various entities described in the present disclosure as well as the functionalities described to be performed by the various entities are intended to mean that the respective entity is adapted to or configured to perform the respective steps and functionalities.

In the claims as well as in the description the word "comprising" does not exclude the presence of other elements or steps.

The indefinite article "a" or "an" does not exclude a plurality. A single element or other unit may fulfill the functions of several entities or items recited in the claims. The mere fact that different dependent claims recite certain measures and features of the converter circuit does not exclude that a combination of these measures and features cannot combined in an advantageous implementation.

## Claims

1. A measuring device (1) to monitor mains supply (2) of a building infrastructure system (20), comprising
a terminal (3) configured to connect the measuring device (1) to a grid, supplying the building infrastructure system with electric power,
measuring means (4) configured to generate measurement values on at least one physical quantity of the mains supply (2) connected to the terminal (3) over time, and
a communication interface (5) configured to enable transfer of the measurement values and/or an analysis result obtained by processing the measurement values in the measuring device (1) to an external device (6).

2. The measuring device (1) according to claim 1, further comprising
a data storage (7) storing at least a plurality of the measurement values and their respective timestamps and/or information received from at least one building infrastructure device (7.1, 7.2, 7.3).

3. The measuring device (1) according to claim 2, further comprising
a processing unit (8) configured to execute an analysis of at least a portion of the stored measurement values.

4. The measuring device (1) according to any one of the preceding claims, wherein
the communication interface (5) is further configured to transfer the measurement values and/or the analysis result to an external data storage (9).

5. The measuring device (1) according to any one of the preceding claims, wherein
the physical quantity of the mains supply (2) comprises at least one of a mains supply voltage, a mains supply input current and a mains supply frequency.

6. The measuring device (1) according to any one of preceding claims, wherein
the measuring device (1) is further configured to read in information from the at least one building infrastructure device (7.1, 7.2, 7.3), and
to store the information in the data storage (7) and/or
to send the read in information from the at least one building infrastructure device (7.1, 7.2, 7.3) to the external device or the external data storage (9).

7. The measuring device (1) according to any one of preceding claims, wherein the measuring device further comprises
a control means (10) configured to generate and output a control signal for controlling operation of the at least one building infrastructure device (7.1, 7.2, 7.3).

8. The measuring device (1) according to claim 7, wherein
the control means (10) is configured to output the control signal to disconnect the at least one building infrastructure device (7.1, 7.2, 7.3) from the mains supply (2).

9. The measuring device (1) according to any one of preceding claims, further comprising
an AC/AC converter (11) to optimize the at least one physical quantity of the mains supply (2) based on the analysis result.

10. The measuring device (1) according to any of proceeding claims, further comprising
a filter (12) configured to provide filtered mains supply to the at least one building infrastructure device (7.1, 7.2, 7.3).

11. The measuring device (1) according to any of proceeding claims, wherein measuring device (1) is further configured
to optimize a driver parameter of the at least one building infrastructure device (7.1, 7.2, 7.3) based on the analysis result obtained by processing the measurement values in the measuring device (1), and
to output the optimized driver parameter of the at least one building infrastructure device (7.1, 7.2, 7.3) to the corresponding building infrastructure device (7.1, 7.2, 7.3).

12. The measuring device (1) according to any of proceeding claims, wherein the measuring device (1) is configured
to read in a driver firmware packet a driver software of the at least one building infrastructure device (7.1, 7.2, 7.3) and to store the driver firmware packet or the driver software of the at least one building infrastructure device (7.1, 7.2, 7.3) in the data storage (7), and
to update the driver firmware packet or the driver software of the at least one building infrastructure device (7.1, 7.2, 7.3).

13. The measuring device (1) according to claim 12, wherein the measuring device (1) is configured
to update the driver firmware packet the driver software of the at least one building infrastructure device (7.1, 7.2, 7.3) automatically at a predetermined time or in response to a predetermined condition.

14. A method for monitoring mains supply (2) of a building infrastructure system (20, 20') comprising a measuring device (1, 1') according to any one of claims 1 to 13, and the method comprises the steps of
generating (S1), by measuring means (4), measurement values on at least one physical quantity of the mains supply (2) connected to the terminal (3) over time,
transferring (S4), by communication interface (5), the measurement values and/or an analysis result obtained by processing at least a portion of the measurement values in a measuring device (1) to an external device (6), and
communicating (S5) with at least one building infrastructure device (7.1, 7.2, 7.3).

15. A building infrastructure system (20) comprising
a measuring device (1) according to any of claims 1 to 15,
at least one building infrastructure device (7.1, 7.2, 7.3) comprising a light driver (7.1, 7.2, 7.3), in particular an LED driver, and
at least one external device (6).
